# EUROPEAN PATENT APPLICATION

(11) **EP 2 579 341 A1**
(43) Date of publication of application: **10.04.2013**
(21) Application number: 11786062.7
(22) Date of filing: 21.05.2011
(51) Int. Cl.: H01L 33/36

(54) **LIGHT EMITTING DIODE WITH THERMORADIATION HEAT-DISSIPATION LAYERS**

(30) Priority: 28.05.2010 CN 201020206922 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074477
(87) International publication number: WO 2011/147290

(57) **Abstract**

A light emitting diode (LED) includes a sapphire substrate, a first thermoradiation heat-dissipation layer, a second thermoradiation heat-dissipation layer, an epitaxy light emitting structure, a first metal contact layer and a second metal contact layer. The first and second thermoradiation heat-dissipation layers are fabricated from a mixture of metal and nonmetal, and are fabricated on the upper and lower surfaces of the sapphire substrate, respectively. The heat generated by the epitaxy light emitting structure propagates through the first and second thermoradiation heat-dissipation layers by directive thermal radiation. The efficiency of heat dissipation is improved to increase the efficiency of light emitting and prolong the lifespan of LED and LED products.

## Description

### BACKGROUND OF THE INVENTION

### 1. Field of the Invention

The present invention generally relates to a light emitting diode (LED), and more specifically to an LED having at least one thermoradiation heat-dissipation layers fabricated on a sapphire substrate and fabricated from a mixture of metal and nonmetal.

### 2. The Prior Arts

An LED has some advantages, including high lumen, low power consumption, long lifespan and high color rendering index. Recently, as the technology of LED makes advanced progress and the peripheral control circuits well develop, the LED has thus drawn much attention in the display and lighting industries and has been widely used in the mobile phone, the backlight module of LCD monitor and television, the projector and general lighting device.

Especially, according to the requirement of Rohs (Restriction of Hazardous Substances Directive) by European Union, LED is considered as one key part in the green industries because of no mercury.

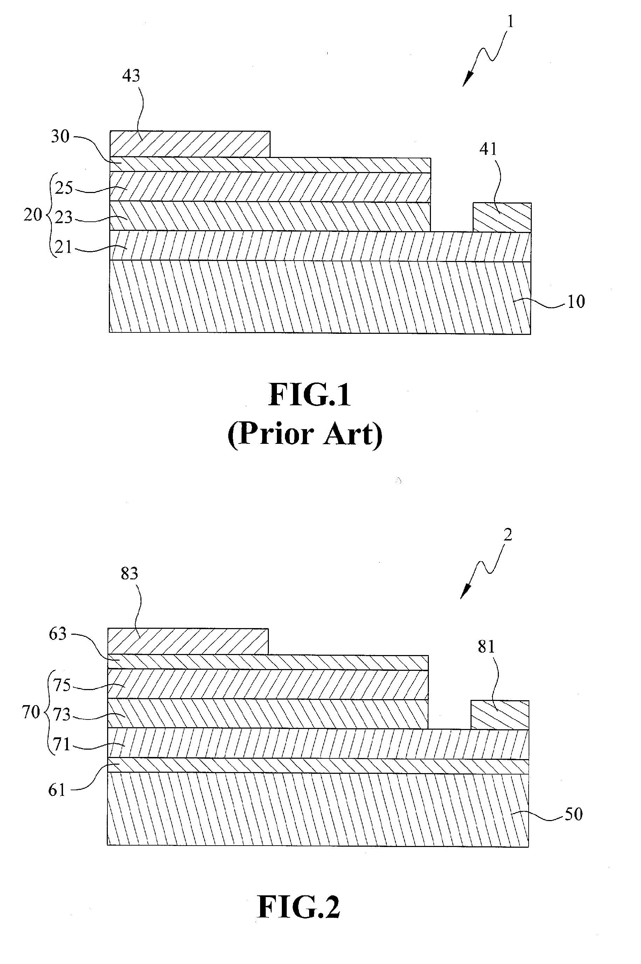

As for the traditional LED, please refer to FIG. 1. The LED 1 in the prior arts generally includes a sapphire substrate 10, an epitaxy light emitting structure 20, an ITO (indium tin oxide) layer 30, a first metal contact layer 41 and a second metal contact layer 43. The sapphire substrate 10 has electrical insulation. The epitaxy light emitting structure 20 is fabricated on the sapphire substrate 10 and includes an N type semiconductor layer 21, a light emitting layer 23 and a P type semiconductor layer 25. The light emitting layer 23 is fabricated from indium gallium nitride or gallium nitride to emit light due to electron-hole recombination.

The ITO layer 30 is transparent and has electrical insulation. Generally, the ITO layer 30 is fabricated on the epitaxy light emitting structure 20 and is connected to the second metal contact layer 43 as a P type contact layer such that the current supplied by an external power source (not shown) is uniformly distributed to avoid addition power consumption. The first metal contact layer 41 is ohmic contact with the N type semiconductor layer 21 and serves as an N type contact layer connected to a negative end of the external power source, and the second metal contact layer 43 is ohmic contact with the upper surface of the transparent heat dissipation film 35 and serves as a P type contact layer connected to a positive end of the external power source.

As high brightness LEDs have been successfully developed and widely used, the electrical power required by the LEDs becomes much higher. As a result, the working temperature of the LED dramatically increases because of poor heat dissipation in the prior arts. The lifespan of the LEDs and the LED products is thus reduced. Therefore, it is a crucial issue to improve the efficiency of heat dissipation.

The feasible solution in the prior arts to the above problem is to increase the effective surface area for heat dissipation through thermal conduction, such as a metal plate with large area fabricated under the circuit board, on which the LEDs are mounted. However, the direction of heat dissipation for thermal conduction is isotropic and the efficiency of heat dissipation is low. Therefore, it is desired to provide a new LED with thermoradiation heat-dissipation layers to overcome the above problems in the prior arts.

### SUMMARY OF THE INVENTION

Therefore, the present invention has been made in view of the above problems, and it is an objective of the present invention to provide an LED with thermoradiation heat-dissipation layers, which includes a sapphire substrate, a first thermoradiation heat-dissipation layer, a second thermoradiation heat-dissipation layer, an epitaxy light emitting structure, a first metal contact layer and a second metal contact layer. The sapphire substrate has a first thermal expansion coefficient and electrical insulation. The first thermoradiation heat-dissipation layer is fabricated on the sapphire substrate, and has a first upper surface and a first lower surface. The first lower surface is in contact with the sapphire substrate. The first thermoradiation heat-dissipation layer has a second thermal expansion coefficient. The epitaxy light emitting structure is fabricated on the first thermoradiation heat-dissipation layer and in contact with the first upper surface. The epitaxy light emitting structure has an N type semiconductor layer, a light emitting layer and a P type semiconductor layer for emitting light by electron-hole recombination. The second thermoradiation heat-dissipation layer is fabricated on the epitaxy light emitting structure, and has a second upper surface and a second lower surface. The second lower surface is in contact with the P type semiconductor layer of the epitaxy light emitting structure, and the second thermoradiation heat-dissipation layer has light transparency and is electrically conductive. The first metal contact layer is ohmic contact with the N type semiconductor layer and connected to a negative end of an external power source, and the second metal contact layer is ohmic contact with the second upper surface of the second thermoradiation heat-dissipation layer and connected to a positive end of the external power source.

The N type semiconductor layer is fabricated from N type gallium nitride, the light emitting layer is fabricated from indium gallium nitride or gallium nitride, and the P type semiconductor layer is fabricated from P type gallium nitride.

The difference between the first and the second thermal expansion coefficients is not greater than 0.1 %, and the difference between the first and the third thermal expansion coefficients is not greater than 0.1%. The first and second thermoradiation heat-dissipation layers are fabricated from a mixture of metal and nonmetal, and the mixture of metal and nonmetal includes a metal compound and a nonmetal compound. The metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound consists of at least one of oxide, nitride and inorganic acid of at least one of boron and carbon.

The first upper surface of the first thermoradiation heat-dissipation layer has a first surface microscopic crystalline structure with crystals, which propagates the heat generated by the epitaxy light emitting structure by thermal radiation in a direction from the first upper surface to the first lower surface. Similarly, the second upper surface of the second thermoradiation heat-dissipation layer has a second surface microscopic crystalline structure with crystals, which propagates the heat generated by the epitaxy light emitting structure by thermal radiation in a direction from the first second surface to the second lower surface. The crystal in the thermoradiation heat-dissipation layers consists of global crystal or polyhedral crystal, such as pyramid octahedral crystal, and the crystal has a grain size of 2 nm to 1 µm. Additionally, the first thermoradiation heat-dissipation layer has a lattice structure matching the N type semiconductor layer or forms an ohmic contact with the N type semiconductor layer, and the second thermoradiation heat-dissipation layer has a lattice structure matching the P type semiconductor layer or forms an ohmic contact with the P type semiconductor layer.

Another objective of the present invention is to provide an LED with thermoradiation heat-dissipation layers, which further consists of a third thermoradiation heat-dissipation layer beneath the sapphire substrate. The third thermoradiation heat-dissipation layer has a third upper surface and a third lower surface. The third thermoradiation heat-dissipation layer is fabricated from the same mixture of metal and nonmetal as the first and second thermoradiation heat-dissipation layers. Also, the third thermoradiation heat-dissipation layer has a third thermal expansion coefficient, which has a difference with the first thermal expansion coefficient not greater than 0.1 %. Besides, the third upper surface of the third thermoradiation heat-dissipation layer has a third surface microscopic crystalline structure to enhance heat dissipation.

More specifically, the thermoradiation heat-dissipation layers can perform heat dissipation by directive thermal radiation, and in particular, the second thermoradiation heat-dissipation layer is used to replace the traditional ITO layer to provide similar electrical and optical properties. Therefore, the efficiency of hat dissipation is greatly improved.

Alternatively, the thermoradiation heat-dissipation layers are fabricated on both surfaces of the sapphire substrate to further increase the efficiency of heat dissipation. The efficiency of light emitting is increased and the lifespan of the LED and LED products is thus prolonged.

### BRIEF DESCRIPTION OF THE DRAWINGS

The present invention can be understood in more detail by reading the subsequent detailed description in conjunction with the examples and references made to the accompanying drawings, wherein:

FIG. 1 is a view showing the LED structure in the prior arts; and

FIG. 2 is a view schematically showing the first embodiment of the LED with thermoradiation heat-dissipation layers according to the present invention; and

FIG. 3 is a view schematically showing the second embodiment of the LED with thermoradiation heat-dissipation layers according to the present invention.

### DETAILED DESCRIPTION OF THE PREFERRED EMBODIMENTS

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

FIG. 2 clearly illustrates the first embodiment of the LED with thermoradiation heat-dissipation layers according to the present invention. As shown in FIG. 2, the LED 2 with thermoradiation heat-dissipation layers of the present invention generally includes a sapphire substrate 50, a first thermoradiation heat-dissipation layer 61, a second thermoradiation heat-dissipation layer 62, an epitaxy light emitting structure 70, a first metal contact layer 81 and a second metal contact layer 83. The sapphire substrate 50 has a first thermal expansion coefficient and electrical insulation. The first thermoradiation heat-dissipation layer 61 is fabricated on the sapphire substrate 50, and has a first upper surface and a first lower surface. The first lower surface is in contact with the sapphire substrate. The first thermoradiation heat-dissipation layer 61 has a second thermal expansion coefficient. The epitaxy light emitting structure 70 is fabricated on the first thermoradiation heat-dissipation layer 61 and is in contact with the first upper surface. The epitaxy light emitting structure 70 has an N type semiconductor layer 71, a light emitting layer 73 and a P type semiconductor layer 75 for emitting light by electron-hole recombination. The second thermoradiation heat-dissipation layer 63 is fabricated on the epitaxy light emitting structure 70, and has a second upper surface and a second lower surface. The second lower surface is in contact with the P type semiconductor layer 75 of the epitaxy light emitting structure 70, and the second thermoradiation heat-dissipation layer 63 has light transparency and is electrically conductive. The first metal contact layer 81 is ohmic contact with the N type semiconductor layer 71 and is connected to a negative end of an external power source (not shown). The second metal contact layer 83 is ohmic contact with the second upper surface of the second thermoradiation heat-dissipation layer 63 and is connected to a positive end of the external power source.

The N type semiconductor layer 71 is fabricated from N type gallium nitride, the light emitting layer 73 is fabricated from indium gallium nitride or gallium nitride, and the P type semiconductor layer 75 is fabricated from P type gallium nitride. The difference between the first and the second thermal expansion coefficients is not greater than 0.1%. The first thermoradiation heat-dissipation layer 61 and the second thermoradiation heat-dissipation layer 63 are fabricated from a mixture of metal and nonmetal, and the mixture of metal and nonmetal includes a metal compound and a nonmetal compound. The metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound consists of at least one of oxide, nitride and inorganic acid of at least one of boron and carbon.

The first upper surface of the first thermoradiation heat-dissipation layer 61 has a first surface microscopic crystalline structure with crystals, which propagates the heat generated by the epitaxy light emitting structure 70 by thermal radiation in a direction from the first upper surface to the first lower surface. Similarly, the second upper surface of the second thermoradiation heat-dissipation layer 63 has a second surface microscopic crystalline structure with crystals, which propagates the heat generated by the epitaxy light emitting structure 70 by thermal radiation in a direction from the first second surface to the second lower surface. The crystal in the thermoradiation heat-dissipation layers 61 and 63 has a grain size of 2 nm to 1 µm and preferably consists of global crystal or polyhedral crystal, such as pyramid octahedral crystal. Further, the first thermoradiation heat-dissipation layer 61 has a lattice structure matching the N type semiconductor layer 71 or forms an ohmic contact with the N type semiconductor layer 71, and the second thermoradiation heat-dissipation layer 63 also has a lattice structure matching the P type semiconductor layer 75 or forms an ohmic contact with the P type semiconductor layer 75.

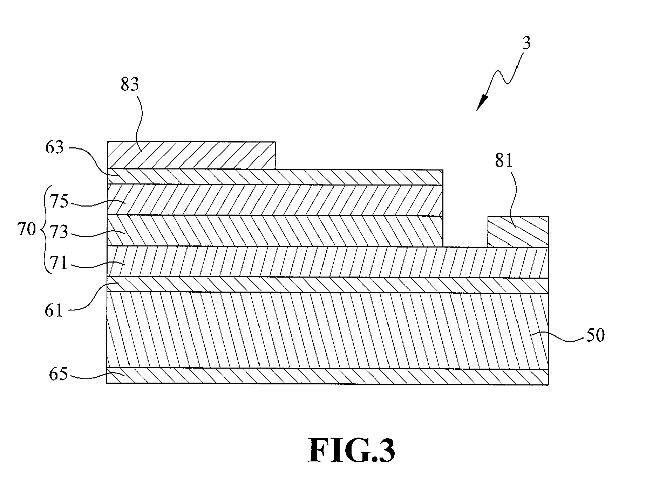

FIG. 3 illustrates the second embodiment of the LED with thermoradiation heat-dissipation layers according to the present invention. As shown in FIG. 3, the LED 3 with thermoradiation heat-dissipation layers of the second embodiment is similar to the LED 2 of the first embodiment in FIG. 2, and the primary difference is that the LED 3 with thermoradiation heat-dissipation layers of the second embodiment further includes a third thermoradiation heat-dissipation layer 65 beneath the sapphire substrate 50. Therefore, the characteristics of the same elements are not described hereafter.

The third thermoradiation heat-dissipation layer 65 has a third upper surface and a third lower surface. The third thermoradiation heat-dissipation layer 65 is fabricated from the same mixture of metal and nonmetal as the first and second thermoradiation heat-dissipation layers 61 and 63. Also, the third thermoradiation heat-dissipation layer 65 has a third thermal expansion coefficient, and the difference between the third thermal expansion coefficient and the first thermal expansion coefficient is not greater than 0.1 %. Besides, the third upper surface of the third thermoradiation heat-dissipation layer 65 has a third surface microscopic crystalline structure to provide further enhanced heat dissipation.

The LED 2 of the present invention further includes a package layer (not shown), which packages the second thermoradiation heat-dissipation layer 63, the epitaxy light emitting structure 70, the first metal contact layer 81 and the second metal contact layer 83 to adjust color temperature (CT) of the emitting light generated by the epitaxy light emitting structure 70.

One aspect of the present invention is that the first thermoradiation heat-dissipation layer fabricated on the sapphire substrate is used to replace the ITO layer to provide similar electrical and optical properties. The second thermoradiation heat-dissipation layer uses the second surface microscopic crystalline structure to provide directive thermal radiation so as to enhance heat dissipation by propagating the heat generated by the epitaxy light emitting structure.

Another aspect of the present invention is that both surfaces of the sapphire substrate are fabricated from the thermoradiation heat-dissipation layers to further improve the efficiency of heat dissipation and light emitting as well as prolonging the lifespan of the LEDs and the LED products.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A light emitting diode (LED) with thermoradiation heat-dissipation layers, comprising:
a sapphire substrate with electrical insulation and a first thermal expansion coefficient;
a first thermoradiation heat-dissipation layer fabricated on the sapphire substrate, and having a first upper surface and a first lower surface, wherein the first upper surface has a first surface microscopic crystalline structure with crystals, and the first thermoradiation heat-dissipation layer is fabricated from a mixture of metal and nonmetal and has a second thermal expansion coefficient;
an epitaxy light emitting structure fabricated on the first thermoradiation heat-dissipation layer and in contact with the first upper surface of the first thermoradiation heat-dissipation layer for emitting light, wherein the epitaxy light emitting structure has an N type semiconductor layer, a light emitting layer and a P type semiconductor layer;
a second thermoradiation heat-dissipation layer fabricated on the epitaxy light emitting structure, and having a second upper surface and a second lower surface, wherein the second lower surface is in contact with the P type semiconductor layer of the epitaxy light emitting structure, the second upper surface has a second surface microscopic crystalline structure with crystals, and the second thermoradiation heat-dissipation layer is fabricated from the mixture of metal and nonmetal and has light transparency and is electrically conductive;
a first metal contact layer being ohmic contact with the N type semiconductor layer and connected to a negative end of an external power source; and
a second metal contact layer being ohmic contact with the second upper surface of the second thermoradiation heat-dissipation layer and connected to a positive end of the external power source;
wherein the first thermoradiation heat-dissipation layer and the second thermoradiation heat-dissipation layer are fabricated from a mixture of metal and nonmetal.

2. The LED as claimed in claim 1, wherein a difference between the first thermal expansion coefficient and the second thermal expansion coefficient is not greater than 0.1 %, the first surface microscopic crystalline structure propagating heat generated by the epitaxy light emitting structure by thermal radiation in a direction from the first upper surface to the first lower surface, the second surface microscopic crystalline structure propagating the heat generated by the epitaxy light emitting structure by thermal radiation in a another direction from the second upper surface to the second lower surface.

3. The LED as claimed in claim 1, wherein the mixture of metal and nonmetal includes a metal compound and a nonmetal compound, the metal compound consisting of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony, and the nonmetal compound consisting of at least one of oxide, nitride and inorganic acid of at least one of boron and carbon.

4. The LED as claimed in claim 1, wherein the N type semiconductor layer is fabricated from N type gallium nitride, the light emitting layer is fabricated from indium gallium nitride or gallium nitride, and the P type semiconductor layer is fabricated from P type gallium nitride.

5. The LED as claimed in claim 1, wherein the first thermoradiation heat-dissipation layer has a lattice structure matching the N type semiconductor layer or forms an ohmic contact with the N type semiconductor layer, and the second thermoradiation heat-dissipation layer has a lattice structure matching the P type semiconductor layer or forms an ohmic contact with the P type semiconductor layer.

6. The LED as claimed in claim 1, wherein the crystal in the thermoradiation heat-dissipation layers consists of global crystal or polyhedral crystal, and the crystal has a grain size of 2 nm to 1 µm.

7. The LED as claimed in claim 6, wherein the polyhedral crystal consists of pyramid octahedral crystal.

8. An LED with thermoradiation heat-dissipation layers, comprising:
a sapphire substrate with electrical insulation and a first thermal expansion coefficient;
a first thermoradiation heat-dissipation layer fabricated on the sapphire substrate, and having a first upper surface and a first lower surface, wherein the first upper surface has a first surface microscopic crystalline structure with crystals, and the first thermoradiation heat-dissipation layer is fabricated from a mixture of metal and nonmetal and has a second thermal expansion coefficient;
an epitaxy light emitting structure fabricated on the first thermoradiation heat-dissipation layer and in contact with the first upper surface of the first thermoradiation heat-dissipation layer for emitting light, wherein the epitaxy light emitting structure has an N type semiconductor layer, a light emitting layer and a P type semiconductor layer;
a second thermoradiation heat-dissipation layer fabricated on the epitaxy light emitting structure, and having a second upper surface and a second lower surface, wherein, the second lower surface is in contact with the P type semiconductor layer of the epitaxy light emitting structure, the second upper surface is fabricated from the mixture of metal and nonmetal and has a second surface microscopic crystalline structure with crystals, and the second thermoradiation heat-dissipation layer has light transparency and is electrically conductive;
a third thermoradiation heat-dissipation layer fabricated beneath the sapphire substrate, and having a third upper surface and a third lower surface, wherein the third upper surface of the third thermoradiation heat-dissipation layer is fabricated from the mixture of metal and nonmetal and has a third surface microscopic crystalline structure with crystals, and the third thermoradiation heat-dissipation layer has a third thermal expansion coefficient;
a first metal contact layer being ohmic contact with the N type semiconductor layer and connected to a negative end of an external power source; and
a second metal contact layer being ohmic contact with the second upper surface of the second thermoradiation heat-dissipation layer and connected to a positive end of the external power source;
wherein the first thermoradiation heat-dissipation layer, the second thermoradiation heat-dissipation layer and the third thermoradiation heat-dissipation layer are fabricated from a mixture of metal and nonmetal.

9. The LED as claimed in claim 8, wherein a difference between the first thermal expansion coefficient and the second thermal expansion coefficient is not greater than 0.1%; an another difference between the first thermal expansion coefficient and the third thermal expansion coefficient is not greater than 0.1%; the first surface microscopic crystalline structure propagating heat generated by the epitaxy light emitting structure by thermal radiation in a direction from the first upper surface to the first lower surface; and the second surface microscopic crystalline structure propagating the heat generated by the epitaxy light emitting structure by thermal radiation in a another direction from the second upper surface to the second lower surface.

10. The LED as claimed in claim 8, wherein the mixture of metal and nonmetal includes a metal compound and a nonmetal compound, the metal compound consisting of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony, and the nonmetal compound consisting of at least one of oxide, nitride and inorganic acid of at least one of boron and carbon.

11. The LED as claimed in claim 8, wherein the N type semiconductor layer is fabricated from N type gallium nitride, the light emitting layer is fabricated from indium gallium nitride or gallium nitride, and the P type semiconductor layer is fabricated from P type gallium nitride.

12. The LED as claimed in claim 8, wherein the first thermoradiation heat-dissipation layer has a lattice structure matching the N type semiconductor layer or forms an ohmic contact with the N type semiconductor layer, and the second thermoradiation heat-dissipation layer has a lattice structure matching the P type semiconductor layer or forms an ohmic contact with the P type semiconductor layer.

13. The LED as claimed in claim 8, wherein the crystal in the thermoradiation heat-dissipation layers consist of global crystal or polyhedral crystal, and the crystal has a grain size of 2 nm to 1 µm.

14. The LED as claimed in claim 13, wherein the polyhedral crystal consists of pyramid octahedral crystal.
